# EUROPEAN PATENT APPLICATION

(11) **EP 4 808 308 A1**
(43) Date of publication of application: **16.09.2026**
(21) Application number: 25227737.1
(22) Date of filing: 30.12.2025
(51) Int. Cl.: H10D 64/01, H10D 64/66

(54) **A METHOD OF PROVIDING A MULTI-LAYER ADHESION LAYER ON A WORKPIECE**

(30) Priority: 14.03.2025 GB 202503756
(71) Applicant: SPTS Technologies Limited, Newport NP18 2TA (GB)
(72) Inventor: JAMES, Gareth Emyr, Newport, NP18 2TA (GB); STARES, Dylan Edward, Newport, NP18 2TA (GB)
(74) Representative: Wynne-Jones IP Limited

(57) **Abstract**

According to the invention there is provided a method of providing a multilayer adhesion layer on a workpiece comprising a semiconductor substrate, the method comprising:
providing a semiconductor substrate having a layer of polysilicon located thereon;
depositing, on the layer of polysilicon, a first layer of titanium having a thickness in the range 5 nanometres to 10 nanometres;
depositing, on the first layer of titanium, a layer of titanium nitride having a thickness in the range 10 nanometres to 25 nanometres; and
depositing, on the layer of titanium nitride, a second layer of titanium having a thickness in the range 20 nanometres to 30 nanometres.

## Description

### Field of the Disclosure

This invention relates to a method of providing a multi-layer adhesion layer on a workpiece comprising a semiconductor substrate, and to related apparatus. This invention relates also to an associated workpiece having a multi-layer adhesion layer provided thereon.

### Background of the Disclosure

During the manufacture of semiconductor devices, such as metal-oxide-semiconductor field-effect transistors (MOSFETs), a metallisation step is typically performed to create contacts, such as gate, source and drain contacts, in a workpiece comprising a semiconductor substrate having a layer of polysilicon located thereon. During the metallisation step, an aluminium alloy can be deposited on the layer of polysilicon at high temperatures to help contribute to any structures, such as trenches or vias, in the workpiece being filled with the aluminium alloy and to help increase the planarity of the deposited metal layer over these structures.

However, polysilicon and aluminium can react at high temperatures to form an aluminium silicon alloy. This reaction is undesirable as the diffusion of aluminium into the silicon can influence performance and reliability of the semiconductor device. To overcome this issue, a barrier layer can be used to separate the polysilicon and aluminium such that these materials are physically separated during the process of depositing the aluminium alloy at high temperatures. The barrier layer can comprise materials such as titanium nitride, which can provide a good diffusive barrier; however, their poor adhesive properties to polysilicon typically require the use of a further layer, such as titanium, located between the polysilicon and titanium nitride to help in adhering the titanium nitride barrier layer to the polysilicon via the layer of titanium.

Using a layer of titanium can have drawbacks, including that some silicon carbide-based semiconductor devices have been shown to suffer from a loss of polysilicon during the metallisation process, forming titanium silicide. Excessive silicide formation can result in a void being formed below the titanium silicide, where exposed polysilicon previously existed, and above the gate oxide and thus can result in an open circuit during electrical testing. On a blanket layer of polysilicon, titanium silicide can present itself as a film of increased thickness, compared to the thickness of the deposited titanium layer. The titanium silicide film can have increased roughness, and there can be extremely localised differences in the thicknesses of the titanium silicide film and the remaining polysilicon.

The prior art advises that the thicknesses of titanium and titanium nitride for silicon-based, and silicon carbide-based, semiconductor devices should be in the range 50 nanometres to 100 nanometres and 100 nanometres to 500 nanometres, respectively, before performing an aluminium metallisation and reflow process, which typically includes aluminium alloys with less than 2% of another element such as copper, silicon, or the like.

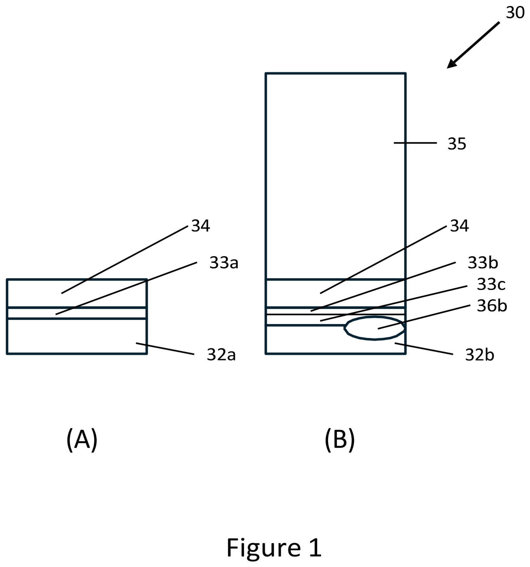

Figure 1A is a schematic representation of a workpiece 30 prior to undergoing an aluminium metallisation deposition and reflow process and Figure 1B is a schematic representation of the workpiece 30 following the aluminium metallisation deposition and reflow process at a temperature between 500 to 560 degrees Celsius. The workpiece 30 shown in Figure 1A comprises a layer of polysilicon 32a, a 50 nanometre layer of titanium 33a and 150-200nm layer of titanium nitride 34. Prior to the aluminium metallisation deposition and reflow process, distinct layers of titanium 33a and titanium nitride 34 can be seen on the layer of polysilicon 32a. The layer of polysilicon 32a can act as a gate contact.

The workpiece 30 shown in Figure 1B comprises a layer of polysilicon 32b, a layer of titanium 33b and a layer of titanium silicide 33c (formed from the reaction of polysilicon 32a with the layer of titanium 33a shown in Figure 1a), voiding 36b between the layer of titanium silicide 33c and the remaining polysilicon 32b, a layer of titanium nitride 34 and a layer of aluminium copper alloy 35 having a thickness of around 4 micrometres. The layer of polysilicon 32b can act as a gate contact. The layers of titanium 33b, titanium nitride 34 and aluminium copper alloy 35 can be deposited via physical vapour deposition and can contribute to the provision of an aluminium interconnect to the layer of polysilicon 32b. The step coverage of the layers of titanium, titanium nitride and aluminium alloy can be substantially conformal. The device characteristics and the resulting device design influence the topography on the surface of the wafer onto which the layers described above are deposited, and in turn influences the thicknesses of the layers of titanium, titanium nitride and aluminium copper alloy, particularly within any features of the wafer. Achieving acceptable aluminium alloy coverage at an acceptable tool throughput frequently requires a high temperature reflow step which can in turn result in silicide formation. The layers of titanium, titanium nitride and aluminium copper alloy contribute to providing an aluminium interconnect to the polysilicon gate contact 32b.

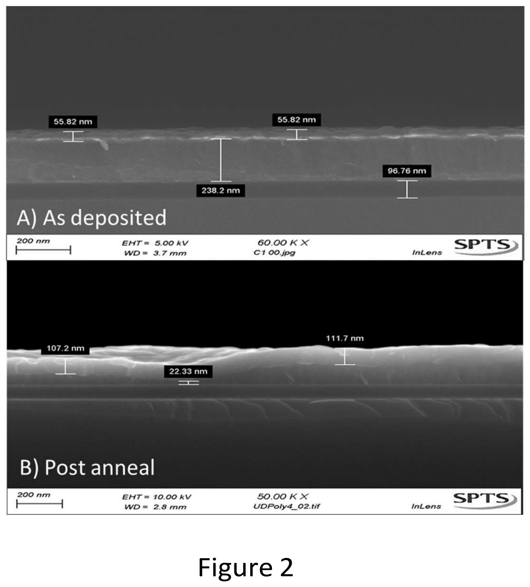

Figure 2A is a scanning electron microscopy image of an approximately 50 to 55 nanometre layer of titanium deposited on an approximately 238 nanometre layer of polysilicon, the layer of polysilicon being deposited on an approximately 100 nanometre layer of thermal oxide on silicon. The layer of titanium was deposited via physical vapour deposition, and the layer of polysilicon was deposited via low pressure chemical vapour deposition.

Figure 2B is a scanning electron microscopy image of the same group of layers as shown in Figure 2a but having undergone a 550 °C anneal indicative of the thermal budget of an aluminium metallisation and reflow process. It can be seen from Figure 2b that titanium silicide has been formed resulting in the consumption of a significant fraction of the polysilicon. In some areas only approximately 22 nanometres of polysilicon remains with a maximum of approximately 112 nanometres (e.g., a consumption of over 126 nanometres of polysilicon). As the main purpose of the layer of titanium is to adhere the titanium nitride barrier layer to the polysilicon while providing a low resistance contact, damaging the contact in this way is undesirable. Similar results were found on both doped and updoped polysilicon.

These effects can be exacerbated when the layers of titanium and titanium nitride are deposited via physical vapour deposition (PVD), as the thicknesses of these layers within a contact, such as a gate contact, can be less (particularly on the side walls of the contact) than the thicknesses of these layers in field areas, due to the directionality of the PVD deposition. This can be compensated to a degree by increasing the film thickness in the field to ensure the correct thickness in the contact is achieved. To achieve the required degree of planarization the thermal budget, time at temperature, and PVD deposition rate result in high temperatures which in turn places more stress on the titanium nitride barrier layer and the titanium-polysilicon contact.

### Statement of Invention

The present invention, in at least some of its embodiments, addresses the above-described problems and desires. In particular, the present invention provides a method and associated apparatus which enable the provision of a multi-layer adhesion layer on a workpiece comprising a semiconductor substrate.

According to a first aspect of the invention there is provided a method of providing a multi-layer adhesion layer on a workpiece comprising a semiconductor substrate, the method comprising:
providing a semiconductor substrate having a layer of polysilicon located thereon;
depositing, on the layer of polysilicon, a first layer of titanium having a thickness in the range 5 nanometres to 10 nanometres;
depositing, on the first layer of titanium, a layer of titanium nitride having a thickness in the range 10 nanometres to 25 nanometres; and
depositing, on the layer of titanium nitride, a second layer of titanium having a thickness in the range 20 nanometres to 30 nanometres.

In this way, an adhesion layer is provided that can reduce the amount of polysilicon consumed when the workpiece is heated by virtue of the thickness of the first layer of titanium and by virtue of the layer of titanium nitride, which can act as a diffusion barrier to help reduce or eliminate titanium from the second layer of titanium contributing to the formation of titanium silicide. The adhesion layer can also provide a low resistivity contact and can aid with stress control within the adhesion layer by virtue of the second layer of titanium. In this way, a reliable contact can be formed with the layer of polysilicon while reducing the formation of titanium silicide.

In other words, the thickness of the first layer of titanium can reduce, or minimise, the amount of polysilicon that is consumed. The layer of titanium nitride can provide a diffusion barrier between the first and second layers of titanium, and can thereby reduce the amount of titanium from the second layer of titanium available to form titanium silicide. The second layer of titanium can contribute to maintaining a low resistivity contact while aiding with stress control within the multi-layer adhesion layer.

The thicknesses of the layers referred to herein can represent dimensions of the layers along an axis perpendicular to the surface of the layer of polysilicon and/or along an axis perpendicular to the surface of the semiconductor substrate.

The first layer of titanium can have a thickness in the range 5 to 7.5 nanometres. The first layer of titanium can have a thickness of about 5 nanometres.

The layer of titanium nitride can have a thickness in the range 17.5 to 22.5 nanometres. The layer of titanium nitride can have a thickness of about 20 nanometres.

The second layer of titanium can have a thickness in the range 22.5 to 27.5 nanometres. The second layer of titanium can have a thickness of about 25 nanometres.

The polysilicon can have a thickness in the range 100 nanometres to 500 nanometres. The polysilicon can have a thickness in the range 100 nanometres to 300 nanometres. In this way, the polysilicon can contribute to the provision of a defined resistance or conductivity.

The polysilicon can be doped. The polysilicon can be doped with one or more gas phase dopants. The polysilicon can be doped through the use of a solid source and a subsequent anneal. A phosphorous based dopant can be used. Doped polysilicon contributes to providing a conductive contact.

The semiconductor substrate can comprise silicon carbide.

The semiconductor substrate can comprise silicon.

The first and second layers of titanium, and the layer of titanium nitride, can be deposited by physical vapour deposition (PVD), typically by sputter deposition.

A common PVD chamber can be used to deposit each of the first and second layers of titanium and the layer of titanium nitride. In this way, the layers of titanium and titanium nitride can be deposited in an efficient manner.

The method can further comprise: depositing, on the second layer of titanium, a second layer of titanium nitride; and depositing, on the second layer of titanium nitride, a layer of aluminium or an aluminium alloy. In this way, an aluminium-based interconnect can be provided.

The aluminium alloy can comprise aluminium and copper (0.5 At%). The aluminium alloy can comprise aluminium and silicon. The layer of aluminium, or aluminium alloy, can be deposited by physical vapour deposition, such as in a cluster tool.

The method can further comprise: after depositing the layer of aluminium, annealing the workpiece by heating the workpiece to a temperature in the range 450 to 650 degrees Celsius, preferably in the range 500 to 600 degrees Celsius, more preferably in the range 540 to 590 degrees Celsius. In this way, the aluminium alloy can undergo reflow which can thereby improve the degree of planarization of the aluminium alloy.

The method can further comprise: depositing, on the second layer of titanium, a second layer of titanium nitride; and depositing, on the second layer of titanium nitride, a layer of tungsten or a tungsten alloy. In this way, a tungsten-based interconnect can be provided.

The layer of tungsten, or tungsten alloy, can be deposited using chemical vapour deposition. The layer of tungsten can form a tungsten plug.

The thickness of the second layer of titanium nitride can be in the range 100 to 500 nanometres.

The thickness of the layer of the aluminium alloy can be in the range 1 to 10 micrometres, preferably 1 to 5 micrometres.

The semiconductor substrate can have a gate oxide located thereon, wherein the workpiece can form a part of a metal-oxide-semiconductor, such as a metal-oxide-semiconductor field-effect transistor (MOSFET).

The layer of polysilicon can cover the gate oxide. In other words, the gate oxide can be located on a first part of the semiconductor substrate, and the layer of polysilicon can be located on both a second part of the semiconductor substrate and the gate oxide.

The layer of polysilicon can have a layer of dielectric material, such as silicon dioxide, located thereon. The layer of dielectric material can isolate (e.g., electrically isolate) the layer of polysilicon. The dielectric material can have an opening defined therein exposing a region of the layer of polysilicon. The opening can expose a region of polysilicon above the gate oxide. In this way, the opening can provide a polysilicon gate contact. This architecture can be used as an interconnect scheme for the gate electrode of a planar silicon carbide MOSFET.

The layer of dielectric material can have a plurality of openings defined therein exposing a plurality of regions of the layer of polysilicon, respectively, wherein the plurality of openings can provide a plurality of polysilicon gate contacts, respectively.

According to a second aspect of the invention there is provided a PVD system for providing a multi-layer adhesion layer on a workpiece comprising a semiconductor substrate, the system comprising:
one or more PVD chambers configured to:
deposit, on a layer of polysilicon located on a semiconductor substrate, a first layer of titanium having a thickness in the range 5 nanometres to 10 nanometres;
deposit, on the first layer of titanium, a layer of titanium nitride having a thickness in the range 10 nanometres to 25 nanometres; and
deposit, on the layer of titanium nitride, a second layer of titanium having a thickness in the range 20 nanometres to 30 nanometres.

The system can comprise a single PVD chamber having a shutter located therein, the shutter configured to divide the chamber into a first compartment in which the semiconductor substrate is positioned and a second compartment in which a titanium target of the physical vapour deposition apparatus is positioned.

The system can comprise further modules as will be appreciated by the skilled reader. For example, the system can comprise a pre-heat module for degassing semiconductor substate and/or an ICP pre-clean module to pre-clean the contact. The pre-heat module can be of any suitable type, such as a lamp-based module.

The system can comprise a module for depositing an aluminium alloy.

According to a third aspect of the invention there is provided a workpiece having a multi-layer adhesion layer provided thereon, the workpiece comprising:
a semiconductor substrate having a layer of polysilicon located thereon;
a first layer of titanium having a thickness in the range 5 nanometres to 10 nanometres, the first layer of titanium being deposited on the layer of polysilicon;
a layer of titanium nitride having a thickness in the range 10 nanometres to 25 nanometres, the layer of titanium nitride being deposited on the first layer of titanium; and
a second layer of titanium having a thickness in the range 20 nanometres to 30 nanometres, the second layer of titanium being deposited on the layer of titanium nitride.

For the avoidance of doubt, whenever reference is made herein to 'comprising' or 'including' and like terms, the invention is also understood to include more limiting terms such as 'consisting' and 'consisting essentially' where the context allows it.

Whilst the invention has been described above, it extends to any inventive combination of the features set out above, or in the following description, drawings or claims. For example, any features disclosed in relation to the first aspect of the invention may be combined with any features disclosed in relation to the second aspect of the invention and vice versa as appropriate.

### Description of the Drawings

Figure 1A is a schematic representation of a workpiece prior to undergoing an aluminium metallisation deposition and reflow process.
Figure 1B is a schematic representation of a workpiece following the aluminium metallisation deposition and reflow process at a temperature between 500 to 560 degrees Celsius.
Figure 2A is a scanning electron microscopy image of a layer of titanium deposited on a layer of polysilicon, the layer of polysilicon being deposited on a layer of silicon dioxide, the layer of silicon dioxide being deposited on a layer of silicon.
Figure 2B is a scanning electron microscopy image of the same group of layers as shown in Figure 2a but having undergone a 550°C anneal.
Figures 3A and 3B show scanning electron microscopy images of a layer of polysilicon having a first layer of titanium having a thickness of 5 nanometres deposited thereon, a layer of titanium nitride having a thickness of 20 nanometres deposited onto the first layer of titanium, and a second layer of titanium having a thickness of 25 nanometres deposited onto the layer of titanium nitride, after having been annealed at a temperature of 580°C for two minutes and after having been annealed at a temperature of 600°C for five minutes, respectively.
Figure 4 shows a schematic representation of a workpiece comprising a layer of polysilicon, a multi-layer adhesion layer comprising a first layer of titanium, a first layer of titanium nitride and a second layer of titanium, a second layer of titanium nitride and a layer of aluminium.
Figure 5 is a schematic representation of an interconnect scheme for a gate electrode of a planar silicon carbide MOSFET.

### Detailed Description of the Disclosure

A novel multi-layer adhesion layer comprising a first layer of titanium, a layer of titanium nitride, and a second layer of titanium was developed to address the problem of consumption of polysilicon when the multi-layer adhesion layer is heated, such as during an aluminium metallisation and reflow process. To limit titanium silicide formation, a first layer of titanium having a thickness of 5 nanometres was applied to a layer of polysilicon, the first layer of titanium acting as an adhesion, or glue, layer. A layer of titanium nitride having a thickness of 20 nanometres was then applied to the first layer of titanium. A second layer of titanium having a thickness of 25 nanometres was then applied to the layer of titanium nitride. The layer of titanium nitride can be referred to as an interstitial layer. The layer of titanium nitride reduces, or avoids, the second layer of titanium from contributing to the formation of titanium silicide. It was established that the layer of titanium nitride isolated the first layer of titanium from the second layer of titanium at temperatures typically used during aluminium metallisation and reflow processes.

Experimental work was conducted using a commercially available apparatus, namely an SPTS Sigma fxP^{™} cluster tool produced by SPTS Technologies Limited (Newport, NP18 2TA, UK), configured for 200mm wafers. The cluster tool was configured with a lamp-based pre-heat module, an Advanced Hi-Fill^{™} (AHF) PVD module with a shutter for titanium and titanium nitride deposition, and a standard aluminium copper PVD module for depositing an aluminium copper alloy having 0.5 At% copper content. Silicon and silicon carbide wafers were used to develop the novel multi-layer titanium-based adhesion layer. The pre-heat module was used to degas the wafers and to perform annealing studies without a vacuum break. Titanium and titanium nitride films were deposited at 200°C using a titanium target and a conventional rotating magnetron with argon and an argon-nitrogen mix, respectively. Film thicknesses were determined by cross sectional scanning electron microscopy examination.

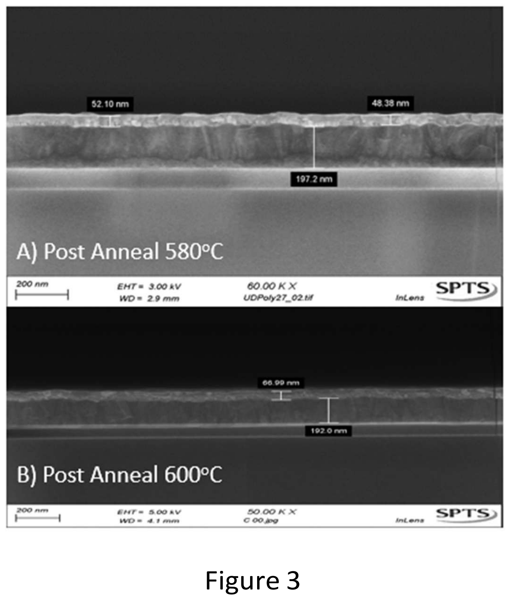

Figures 3A and 3B show images obtained via scanning electron microscopy of a layer of polysilicon having a first layer of titanium having a thickness of 5 nanometres deposited thereon, a layer of titanium nitride having a thickness of 20 nanometres deposited onto the first layer of titanium, and a second layer of titanium having a thickness of 25 nanometres deposited onto the layer of titanium nitride, after having been annealed at a temperature of 580°C for two minutes and after having been annealed at a temperature of 600°C for five minutes, respectively.

Annealing at a temperature of 580°C for two minutes is representative of a high temperature aluminium metallisation and reflow process. It can be seen that the total thickness of the first and second layers of titanium and the layer of titanium nitride is still approximately 50 nanometres while the thickness of the polysilicon is unchanged at approximately 200 nanometres. This shows that the first layer of titanium did not react with the polysilicon to form titanium silicide.

Figure 3B shows evidence of titanium silicide formation and a small amount (approximately 8 to 10 nanometres) of polysilicon loss.

**Table 1. Titanium (Ti) and polysilicon conversion to titanium silicide (TiSi₂) for Figure 3b.**

| | Ti/TiN/Ti (nm) | Ti #1 to TiSi₂ (nm) | Extra Ti thickness (nm) | Polysilicon (nm) | Polysilicon to TiSi₂ (nm) | Extra Ti thickness (nm) |
|---|---|---|---|---|---|---|
| Initial value | 50 | | | 200 | | |
| Post 600°C anneal | 67 | | | 192 | | |
| Ti to TiSi₂ change | 17 | 12.55 | 1.77 | 8 | 11.35 | 1.48 |

According to Nomura (Ohmic Contact Formation on N-Type 6H-SiC Using Poly-Si and Silicides, 19th Annual Microelectronic Engineering Conference, May 2001, 58-62), a first layer of titanium (e.g., the layer of titanium in contact with the layer of polysilicon) having a thickness of 5 nanometres should equate to 2.51 times the thickness of the first layer of titanium resulting in 12.55 nanometres of titanium silicide if the first layer of titanium is fully converted into titanium silicide, while the loss of polysilicon would be expected to be 2.27 times the thickness of the first layer of titanium resulting in a loss of 11.35 nanometres of polysilicon. Both measurements are likely with the errors of the measurement or indicate that a small amount (e.g., 1.48 to 1.77 nanometres) of the second layer of titanium (e.g., separated from the first layer of titanium via a layer of titanium nitride) diffused through the titanium nitride diffusion barrier layer. All of the first layer of titanium (which was initially 5 nanometres) reacted with the polysilicon to form titanium silicide.

Following deposition of the first and second layers of titanium and the layer of titanium nitride, a second layer of titanium nitride was deposited onto the second layer of titanium. Following deposition of the second layer of titanium nitride, a layer of an aluminium alloy having 0.5 At% copper content was deposited via an aluminium metallisation and reflow process. The second layer of titanium nitride can be referred to as a barrier layer.

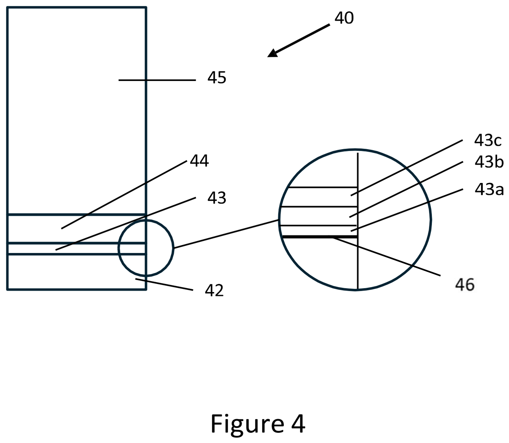

Figure 4 shows a schematic representation of a workpiece 400 comprising a layer of polysilicon 42 (which can be referred to as a polysilicon contact), a multi-layer adhesion layer 43 comprising a first layer of titanium 43a, a first layer of titanium nitride 43b and a second layer of titanium 43c, a second layer of titanium nitride 44 and a layer of aluminium 45. The total thickness of the multi-layer adhesion layer 43 is approximately 50 nanometres. The second layer of titanium nitride has a thickness of 100 nanometres; however, this can be in the range 100 to 500 nanometres. The first and second layers of titanium, and the first and second layers of titanium nitride, are deposited via PVD. The first and second layers of titanium, and the first and second layers of titanium nitride, are deposited using PVD modules with a titanium target. The layer of aluminium is deposited by PVD and is heated to an elevated temperature (e.g., 550°C) to enable reflow to occur. The layer of aluminium is deposited by PVD using an aluminium, or aluminium alloy, target. The layer of aluminium is deposited by PVD in the same cluster tool as for the first and second layers of titanium and the first and second layers of titanium nitride. However, the layer of aluminium could be deposited by PVD that is not in the same cluster tool. A thin layer of titanium silicide 46 forms during heating.

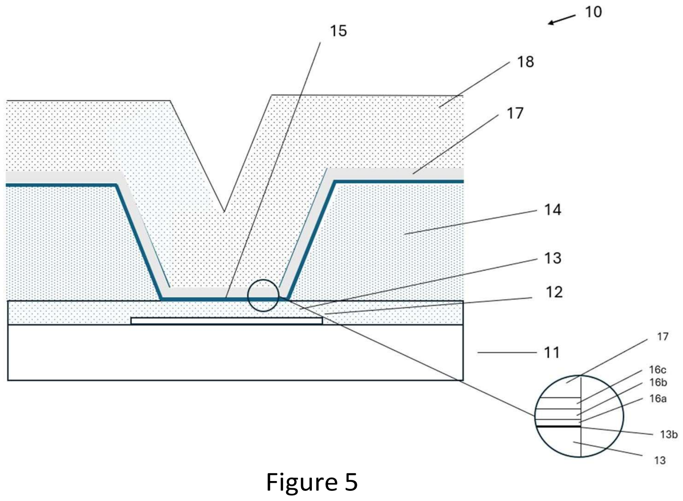

Figure 5 is a schematic representation of an interconnect scheme 10 for a gate electrode of a planar silicon carbide MOSFET. The interconnect scheme 10 has a silicon carbide substrate 11 (the silicon carbide substrate having epitaxial layers thereon), a gate oxide 12 covered by a doped polysilicon contact 13, the gate oxide 12 being isolated by a silicon dioxide dielectric layer 14. To make an electrical connection to the polysilicon contact 13, a contact opening 15 is formed in the dielectric 14 by conventional photolithography and dry etch, or strip, means. A SynapseEtch^{™} ICP module (manufactured by SPTS Technologies Limited) is highly suited for this step, owning to the high density plasma produced, though other etching apparatus might be used for this purpose. With the polysilicon 13 exposed above the gate oxide, a first layer of titanium 16a is deposited by physical vapour deposition (PVD) into the feature and over the surface of the dielectric layer 14. The first layer of titanium 16a acts as an adhesion layer. Following deposition of the first layer of titanium 16a, a titanium nitride barrier layer 16b is then deposited onto the first layer of titanium. The first layer of titanium 16a acts to adhere the layer of titanium nitride to the polysilicon contact 13. A second layer of titanium 16c is then deposited onto the layer of titanium nitride. Typically, these steps are conducted without a vacuum break. The first and second layers of titanium and the layer of titanium nitride are deposited using one module (namely an SPTS Sigma fxP^{™} cluster tool as described herein) which is capable of depositing both titanium and titanium nitride. However, this could be performed in two separated modules (e.g., a first module for depositing titanium and a second module for depositing titanium nitride). Following the deposition of the first and second layers of titanium and the layer of interstitial titanium nitride, a thicker second layer of titanium nitride 17 is deposited followed by a bulk conductor layer of an aluminium alloy 18 is deposited. However, aluminium could also be used. This step is also conducted in the same cluster tool but using a separate module to the module, or modules, used for depositing the layers of titanium and titanium nitride. A layer of titanium silicide 13b forms during an aluminium, or aluminium alloy, high temperature reflow step.

Many variations are possible. For example, the thickness of the first layer of titanium can be in the range 5 nanometres to 10 nanometres. Thicknesses in this range resulted in the first layer of titanium acting as an adhesion layer while reducing the formation of titanium silicide.

The thickness of the layer of titanium nitride can be in the range 10 nanometres to 25 nanometres. Thicknesses in this range resulted in the layer of titanium nitride reducing, or avoiding, the second layer of titanium from contributing to the formation of titanium silicide.

The multi-layer adhesion layer described herein has a variety of applications, including in semiconductor devices such as MOSFETs and the like.

## Claims

1. A method of providing a multi-layer adhesion layer on a workpiece comprising a semiconductor substrate, the method comprising:
providing a semiconductor substrate having a layer of polysilicon located thereon;
depositing, on the layer of polysilicon, a first layer of titanium having a thickness in the range 5 nanometres to 10 nanometres;
depositing, on the first layer of titanium, a layer of titanium nitride having a thickness in the range 10 nanometres to 25 nanometres; and
depositing, on the layer of titanium nitride, a second layer of titanium having a thickness in the range 20 nanometres to 30 nanometres.

2. A method according to claim 1, wherein the first layer of titanium has a thickness in the range 5 to 7.5 nanometres.

3. A method according to claim 1 or claim 2, wherein the layer of titanium nitride has a thickness in the range 17.5 to 22.5 nanometres.

4. A method according to any preceding claim, wherein the second layer of titanium has a thickness in the range 22.5 to 27.5 nanometres.

5. A method according to any preceding claim, wherein the polysilicon has a thickness in the range 100 nanometres to 500 nanometres, preferably in the range 100 nanometres to 300 nanometres.

6. A method according to any preceding claim, wherein the semiconductor substrate comprises silicon carbide.

7. A method according to any preceding claim, wherein the first and second layers of titanium, and the layer of titanium nitride, are deposited by physical vapour deposition (PVD).

8. The method according to claim 7, wherein a common PVD chamber is used to deposit each of the first and second layers of titanium and the layer of titanium nitride.

9. A method according to any preceding claim, the method further comprising:
depositing, on the second layer of titanium, a second layer of titanium nitride; and
depositing, on the second layer of titanium nitride, a layer of aluminium or an aluminium alloy.

10. A method according to claim 9, wherein the method further comprises:
after depositing the layer of aluminium, annealing the workpiece by heating the workpiece to a temperature in the range 450 to 650 degrees Celsius, preferably in the range 500 to 600 degrees Celsius, more preferably in the range 540 to 590 degrees Celsius.

11. A method according to any of claims 1 to 8, the method further comprising:
depositing, on the second layer of titanium, a second layer of titanium nitride; and
depositing, on the second layer of titanium nitride, a layer of tungsten or a tungsten alloy.

12. A method according to any of claims 9 to11, wherein the thickness of the second layer of titanium nitride is in the range 100 to 500 nanometres.

13. A method according to any preceding claim, wherein the semiconductor substrate has a gate oxide located thereon, and wherein the workpiece forms a part of a metal-oxide-semiconductor, such as a MOSFET

14. A PVD system for providing a multi-layer adhesion layer on a workpiece comprising a semiconductor substrate, the system comprising:
one or more PVD chambers configured to:
deposit, on a layer of polysilicon located on a semiconductor substrate, a first layer of titanium having a thickness in the range 5 nanometres to 10 nanometres;
deposit, on the first layer of titanium, a layer of titanium nitride having a thickness in the range 10 nanometres to 25 nanometres; and
deposit, on the layer of titanium nitride, a second layer of titanium having a thickness in the range 20 nanometres to 30 nanometres.

15. A system according to claim 14, the system comprising a single PVD chamber having a shutter located therein, the shutter configured to divide the chamber into a first compartment in which the semiconductor substrate is positioned and a second compartment in which a titanium target of the physical vapour deposition apparatus is positioned.

16. A workpiece having a multi-layer adhesion layer provided thereon, the workpiece comprising:
a semiconductor substrate having a layer of polysilicon located thereon;
a first layer of titanium having a thickness in the range 5 nanometres to 10 nanometres, the first layer of titanium being deposited on the layer of polysilicon;
a layer of titanium nitride having a thickness in the range 10 nanometres to 25 nanometres, the layer of titanium nitride being deposited on the first layer of titanium; and
a second layer of titanium having a thickness in the range 20 nanometres to 30 nanometres, the second layer of titanium being deposited on the layer of titanium nitride.

## Amended claims

### Amended claims in accordance with Rule 137(2) EPC.

1. A method of providing a multi-layer adhesion layer (43) on a workpiece (400) comprising a semiconductor substrate (11), the method comprising:
providing a semiconductor substrate having a layer of polysilicon (42) located thereon;
depositing, on the layer of polysilicon, a first layer of titanium (43a) having a thickness in the range 5 nanometres to 10 nanometres;
depositing, on the first layer of titanium, a layer of titanium nitride (43b) having a thickness in the range 10 nanometres to 25 nanometres; and
depositing, on the layer of titanium nitride, a second layer of titanium (43c) having a thickness in the range 20 nanometres to 30 nanometres.

2. A method according to claim 1, wherein the first layer of titanium has a thickness in the range 5 to 7.5 nanometres.

3. A method according to claim 1 or claim 2, wherein the layer of titanium nitride has a thickness in the range 17.5 to 22.5 nanometres.

4. A method according to any preceding claim, wherein the second layer of titanium has a thickness in the range 22.5 to 27.5 nanometres.

5. A method according to any preceding claim, wherein the polysilicon has a thickness in the range 100 nanometres to 500 nanometres, preferably in the range 100 nanometres to 300 nanometres.

6. A method according to any preceding claim, wherein the semiconductor substrate comprises silicon carbide.

7. A method according to any preceding claim, wherein the first and second layers of titanium, and the layer of titanium nitride, are deposited by physical vapour deposition (PVD).

8. The method according to claim 7, wherein a common PVD chamber is used to deposit each of the first and second layers of titanium and the layer of titanium nitride.

9. A method according to any preceding claim, the method further comprising:
depositing, on the second layer of titanium, a second layer of titanium nitride (44); and
depositing, on the second layer of titanium nitride, a layer of aluminium or an aluminium alloy (45).

10. A method according to claim 9, wherein the method further comprises:
after depositing the layer of aluminium, annealing the workpiece by heating the workpiece to a temperature in the range 450 to 650 degrees Celsius, preferably in the range 500 to 600 degrees Celsius, more preferably in the range 540 to 590 degrees Celsius.

11. A method according to any of claims 1 to 8, the method further comprising:
depositing, on the second layer of titanium, a second layer of titanium nitride; and
depositing, on the second layer of titanium nitride, a layer of tungsten or a tungsten alloy.

12. A method according to any of claims 9 to11, wherein the thickness of the second layer of titanium nitride is in the range 100 to 500 nanometres.

13. A method according to any preceding claim, wherein the semiconductor substrate has a gate oxide located thereon, and wherein the workpiece forms a part of a metal-oxide-semiconductor, such as a MOSFET

14. A workpiece (400) having a multi-layer adhesion layer (43) provided thereon, the workpiece comprising:
a semiconductor substrate (11) having a layer of polysilicon (42) located thereon;
a first layer of titanium (43a) having a thickness in the range 5 nanometres to 10 nanometres, the first layer of titanium being deposited on the layer of polysilicon;
a layer of titanium nitride (43b) having a thickness in the range 10 nanometres to 25 nanometres, the layer of titanium nitride being deposited on the first layer of titanium; and
a second layer of titanium (43c) having a thickness in the range 20 nanometres to 30 nanometres, the second layer of titanium being deposited on the layer of titanium nitride.
